# EUROPEAN PATENT APPLICATION

(11) **EP 1 653 315 A1**
(43) Date of publication of application: **03.05.2006**
(21) Application number: 04105351.3
(22) Date of filing: 28.10.2004
(51) Int. Cl.: G05F 1/46, G11C 5/14, G05F 3/26

(54) **An improved voltage down converter**

(71) Applicant: STMicroelectronics S.r.l., 20041 Agrate Brianza (Milano) (IT)
(72) Inventor: Pisasale, Michelangelo, 95100 Catania (CT) (IT); Gaibotti, Maurizio, 20031 Cesano Maderno (IT); La Placa, Michele, 90015 Cefalu' (PA) (IT)
(74) Representative: Maccalli, Marco

(57) **Abstract**

A voltage down converter (200) includes voltage regulator means (205) receiving a first voltage (Vdd) and having a regulation node for providing a regulated second voltage (Vr) lower than the first voltage, and having a control node for providing a control voltage (Vg) corresponding to the second voltage; and a voltage driver circuit branch (220) receiving the first voltage and including a variable-conductivity element (Tsb) having a control terminal coupled to the control node for controlling a current sunk by the variable-conductivity element from the first voltage; The voltage driver circuit branch has a voltage supply node (Vo), for supplying a down-converted voltage (Vo) corresponding to the second voltage, which is decoupled from the regulation node. At least one additional voltage driver circuit branch (225-1 - 225-N) is provided, receiving the first voltage and coupled to the voltage supply node, and including: a further variable-conductivity element (T-1 - T-N) having a control terminal coupled to the control node for controlling a current sunk by the further variable-conductivity element from the first voltage; and switching means (SW-1 - SW-N) for selectively enabling the further variable-conductivity element so as to keep the down-converted voltage at a prescribed value depending on the regulated second voltage.

## Description

The present invention relates to a voltage down converter, in particular to a voltage down converter for use in a semiconductor memory device, such as a non-volatile memory.

Nowadays, many semiconductor memory devices are designed so as to be adapted for operating with low supply voltages, such as supply voltages down to 1.8 V. Considering, for example, a non-volatile semiconductor memory device, *e.g*., an E²PROM of flash type, the use of a relatively low supply voltage permits to exploit technologies with very thin gate oxide layers, *e.g*. of thickness lower than 50 Å. Accordingly, it is possible to implement semiconductor memory devices that are more compact, and that feature low power consumption.

There is however a number of applications in which the memory devices, albeit adapted to operate at very low power supply voltage values, are nevertheless required to operate at higher supply voltages, such as supply voltages of 3 V (nominal) or more; this is for example the case when a memory device of a new generation has to be exploited in a system, *e.g*. a printed circuit board, of a previous generation, working at a higher supply voltage.

In order to avoid the necessity of fully redesigning all the existing electronic system environments in which the memory devices can be used, so as to reduce the power supply value, countermeasures are taken by the memory device manufacturers so as to render their products directly exploitable in existing electronic system designs working at a higher supply voltage, at the same time avoiding that the tiny structures of the memory device are damaged.

As a typical countermeasure, dc-dc voltage down converters are used, for down-converting, i.e., lowering the externally received supply voltage to a suitably lower voltage. Preferably, the voltage down converters are integrated, i.e., embedded in the same chip of the memory device.

Voltage down converters known in the art consist of a voltage regulator coupled to an internal voltage supply line (internal to the chip) that distributes a properly down-converted voltage through the memory device chip providing it to different circuits of the memory device.

An implementation of these known voltage down converters consists of an operational amplifier coupled to a MOS transistor, which can be either an n-MOS or a p-MOS transistor, in negative feed-back configuration. Particularly, an output terminal of the operational amplifier is coupled to the gate terminal of the MOS transistor. The MOS transistor is coupled to the internal voltage supply line and the current sunk by the MOS transistor, regulated by means of the operational amplifier, is exploited to satisfy a current request of circuits of the memory devices. For performing a regulation of the down-converted voltage, the internal voltage supply line coupled to the MOS transistor is feed-back connected to one of the input terminals of the operational amplifier, while the other input terminal receives a reference voltage. Any variation of the voltage difference at the input terminals of the operational amplifier implies a change in the drive for the MOS transistor, and consequently a variation of the current sunk by the MOS transistor. By properly sizing a feed-back circuit branch, the internal voltage supply line can be kept at the desired down-converted voltage.

A problem of such a solution is the output voltage stability (response speed is limited by heavy frequency compensation), because capacitive loads coupled to the internal voltage supply line dynamically vary depending on the operations performed on the memory device (different circuits may be activated, depending on the operations). The voltage down converter circuit cannot track the relatively fast changes in the requested current.

Another solution known in the art decouples the feed-back circuit branch of the voltage regulator from the internal voltage supply line by adding a further MOS transistor having, as the MOS transistor inserted in the feed-back loop, the gate terminal connected to the output terminal of the operational amplifier. In this case, the regulation of the voltage at the nodes of the feed-back circuit branch is not influenced by any variation of the loads at the internal voltage supply line, and a current request of the circuits of the memory device can be satisfied by the further MOS transistor having the gate terminal biased at the same voltage as the gate terminal of the MOS transistor of the voltage regulator.

However, this further, open-loop solution, in which the internal voltage supply line is decoupled from the voltage regulator, does not permit to maintain the desired down-converted voltage at the internal voltage supply line because of the dynamical variations of the loads during the operation of the memory device (the regulation characteristic of the circuit has in fact a relatively high slope).

In addition, in both the above-described solutions, transients in the down-converted voltage value caused by variations of the loads can have relatively long duration, at best some tens of nanoseconds. This is not compatible with the operation of a flash memory device, that requires current pulses of amplitude of tens of milliampère and duration of less than ten nanoseconds, and that must respect response times (access times) in the order of 50 ns.

In view of the state of the art outlined in the foregoing, one of the problems that the Applicant has faced has been how to provide an improved voltage down converter for the use in an integrated circuit, in particular a semiconductor memory, particularly a voltage down converter that is stable, with relatively low response times, and which permits to regulate the down-converted voltage also when the loads dynamically change.

According to an aspect of the present invention, a voltage down converter is provided as set forth in the appended claim 1.

Summarizing, the voltage down converter includes:
voltage regulator means receiving a first voltage and having a regulation node for providing a regulated second voltage lower than the first voltage, and having a control node for providing a control voltage corresponding to the second voltage; and
a voltage driver circuit branch receiving the first voltage and including a variable-conductivity element having a control terminal coupled to the control node for controlling a current sunk by the variable-conductivity element from the first voltage, the voltage driver circuit branch having a voltage supply node for supplying a down-converted voltage corresponding to the second voltage, the voltage supply node being decoupled from the regulation node.

The voltage down converter further includes at least one additional voltage driver circuit branch receiving the first voltage and coupled to the voltage supply node, and including:
a further variable-conductivity element having a control terminal coupled to the control node for controlling a current sunk by the further variable-conductivity element from the first voltage; and
switching means for selectively enabling the further variable-conductivity element so as to keep the down-converted voltage at a prescribed value depending on the regulated second voltage.

In other words, according to the present invention, there is provided a modulation of the size (for example, in the case of MOS transistors, the channel width W), and, thus, of the current capability of an hypothetical variable-conductivity element equivalent to the combination of the variable-conductivity element in the voltage driver circuit branch, and of the further variable-conductivity element(s) in the at least one additional voltage driver circuit branch: when more current is required, the size of the hypothetical equivalent variable-conductivity element is increased, whereas the contrary takes place when the current consumption decrease.

According to another aspect of the present invention, a method of down-converting a voltage, as set forth in the appended claim 10, is further provided.

The features and the advantages of the present invention will be made apparent by the following detailed description of a preferred embodiment thereof, provided merely by way of non-limitative example, description that will be conducted making reference to the attached figures, in which:
Fig. 1 shows schematically a flash memory integrated on a chip of semiconductor material, particularly a memory including a voltage down converter according to an embodiment of the present invention;
Fig. 2 shows in greater detail the voltage down converter of Fig. 1, according to an embodiment of the present invention;
Fig. 3 illustrates a comparator included in a control unit of the voltage down converter of Fig. 2 according to an embodiment of the present invention;
Figs. 4A and 4B illustrate a signal output by the comparator of Fig. 3 *vs.* time obtained by simulation conducted by the Applicant;
Fig. 5 shows a comparator included in the control unit of the voltage down converter of Fig. 2 according to another embodiment of the present invention.

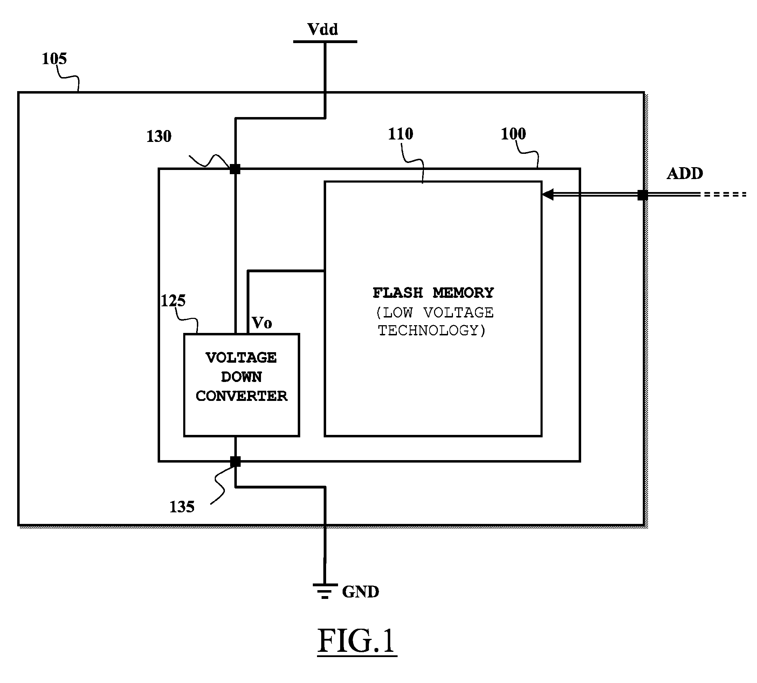

With reference to the drawings, in particular to Fig. 1, an integrated circuit 100, comprising a semiconductor memory device, particularly a non-volatile semiconductor memory 110, realized in a low-voltage manufacturing technology, for example an E²PROM, particularly of flash type, is schematically illustrated. The integrated circuit 100 is integrated in a chip 105 of semiconductor material. The flash memory 110 typically includes a matrix of memory cells, for example consisting of floating gate MOS transistors, and a variety of circuit blocks, such as decoders used to select the memory cells, for example in response to a corresponding address ADD received from the outside, and read/write circuits, which are used to read/update a content of the selected memory cells. Particularly, the read/write circuits include the components necessary to execute read and write (and, possibly, erase) operations on the selected memory cells, such as program loads, sense amplifiers, pulse generators, and the like.

The integrated circuit 100 further includes a dc-dc Voltage Down Converter (VDC) 125, coupled to a voltage supply terminal 130 and to a reference voltage terminal 135 of the integrated circuit; when the memory is in use (for example, it is mounted on a printed circuit board (not shown), the voltage supply terminal 130 and the reference voltage terminal 135 are respectively connected to an external voltage supply line Vdd and to an external reference voltage supply line GND. The voltage supply line Vdd provides a supply voltage Vdd, for example +3V relative to a reference voltage (or ground) provided by the reference voltage supply line GND. The VDC 125 generates, internally to the chip, a down-converted voltage Vo, which is supplied to the different circuits of the flash memory 110, particularly to the decoders and the read/write circuits; the down-converted voltage Vo can take a down-converted voltage value, such as 1.8 V. In this way, although the memory is designed and fabricated in a low-voltage technology, adapted to operate at low voltages, the integrated circuit 100 might be exploited in environments in which the supply voltage values are still relatively high.

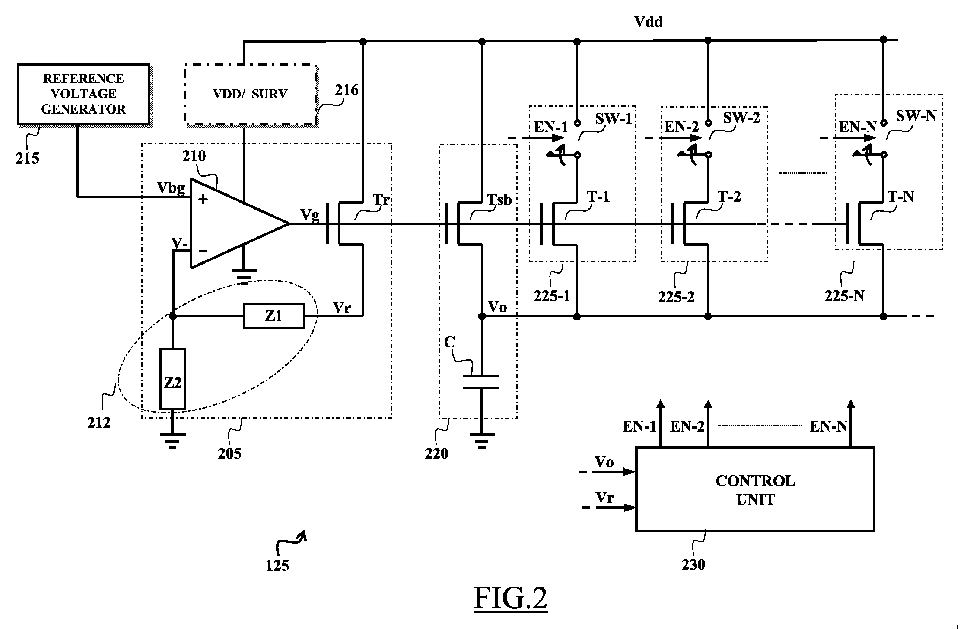

Considering now Fig. 2, a more detailed circuit diagram of the VDC 125, according to an embodiment of the present invention is shown.

The VDC 125 includes a voltage regulator 205 coupled to the voltage supply terminal 130, and thus to the voltage supply line Vdd, and to the reference voltage terminal 135, and thus to the reference voltage supply line GND, for receiving the supply voltage Vdd and the ground, respectively. The voltage regulator 205 comprises an operational amplifier 210, supplied between the ground and the supply voltage Vdd, which receives, at a non-inverting input terminal "+" thereof, a reference voltage Vbg, supplied thereto by a reference voltage generator 215, included for example in the VDC. Preferably, the reference voltage generator 215 includes a band-gap reference voltage generator, capable of providing a band-gap reference voltage Vbg which is very stable, particularly against operating temperature variations.

The voltage regulator 205 further includes an n-MOS transistor Tr having a gate terminal connected to an output terminal of the operational amplifier 210, said output terminal supplying a gate drive voltage Vg to the gate terminal of the transistor Tr, and the drain terminal coupled to the voltage supply line Vdd.

The voltage regulator 205 includes a negative feed-back circuit branch 212 between the output terminal and an inverting input terminal "-" of the operational amplifier 210. The negative feed-back circuit branch 212 includes a first bipole Z1 and a second bipole Z2, for example both consisting of a respective resistor of suitable resistance. In detail, the first bipole Z1 has a first terminal connected to the source terminal of the transistor Tr and a second terminal connected to the inverting input terminal "-" of the operational amplifier 210 together with a first terminal of the second bipole Z2; the second bipole Z2 has a second terminal connected to ground. In operation, the voltage regulator 205 is adapted to cause the source terminal of the transistor Tr to reach a prescribed, regulated voltage Vr.

The VDC 125 further includes a stand-by voltage driver 220 for providing the down-converted voltage Vo, to circuits of the flash memory during a memory stand-by condition. Particularly, the stand-by voltage driver 220 includes an n-MOS transistor Tsb and a capacitor C. The transistor Tsb has a gate terminal connected to the output terminal of the operational amplifier 210, and then driven by the same gate voltage Vg as the transistor Tr. The drain terminal of the transistor Tsb is coupled to the (voltage supply terminal 130 and thus to the) supply voltage line Vdd, while the source terminal is connected to a first terminal of the capacitor C; a second terminal of the capacitor C is connected to ground. In operation, particularly during stand-by, the first terminal of the capacitor C is intended to reach the down-converted voltage Vo.

The down-converted voltage Vo is provided to the flash memory 110 and thus to its internal circuits by means of a down-converted voltage supply line, identified in the drawings by the same reference numeral Vo, accordingly coupled to electric loads which vary depending on the operations to be performed on the flash memory. The capacitor C, decoupled from the voltage regulator 205, is sized in such a way as to hold a desired voltage Vo by means of a current sunk by the transistor Tsb during the stand-by condition of the flash memory; for example, the capacitor C has a capacitance of only about 2 nF.

Furthermore, the VDC 125 according to the presently described embodiment of the invention comprises at least one, preferably a number N (for example, 60) of additional voltage drivers 225-1 - 225-N, connected in parallel to the stand-by voltage driver 220 between the voltage supply Vdd and the ground. Each generic additional voltage driver 225-i (where i is an index equal to 1,...,N) includes an n-MOS transistor T-1 ― T-N having a gate terminal coupled to the output terminal of the operational amplifier 210, and then driven by the same gate voltage Vg as the transistors Tr and Tsb, and a source terminal coupled to the down-converted voltage supply line Vo. For example, all the transistors T-1 - T-N of the additional voltage drivers 225-1 - 225-N have a same size and a same current drive capability of 0.7 mA.

Each generic additional voltage driver 225-i also includes a switch SW-i for selectively decoupling the respective n-MOS transistor T-i from the voltage supply line Vdd. In the considered example the switch SW-i (e.g., simply implemented by a p-MOS transistor, although any other implementation known in the art is suitable) has a first terminal connected to the drain terminal of the transistor T-i and a second terminal coupled to the (voltage supply terminal 130, and thus to the) voltage supply line Vdd.

The VDC 125 further comprises a control unit 230 that receives the down-converted voltage Vo and the regulated voltage Vr, and that provides enabling signals EN-1 ― EN-N for selectively enabling (activating) respective switches SW-1 - SW-N in accordance with a result of a comparison of the down-converted voltage Vo and the regulated voltage Vr. During a stand-by condition of the flash memory, all the switches SW-1- SW-N are preferably kept disabled.

The VDC 125 has to provide the down-converted voltage Vo at the desired value also when the flash memory is operating and the loads coupled to the down-converted voltage supply line Vo varies depending on the operations to be performed. Particularly, the VDC 200 has to provide the down-converted voltage Vo approximately equal to the regulated voltage Vr at a node of the voltage regulator 205 decoupled from the down-converted voltage supply line Vo.

The voltage regulator 205 permits to obtain the desired regulated voltage Vr thanks to the negative feed-back that varies the current sunk by the transistor Tr depending on the difference between the band-gap reference voltage Vbg and a voltage V- at the inverting input terminal "-" of the operational amplifier 210. In detail, if the voltage V- is lower than the band-gap reference voltage Vbg, the gate voltage Vg increases, in turn causing an increase of the current sunk by the transistor Tr. Accordingly, a current flowing through the two bipoles Z1 and Z2 increases, thereby causing an increase of the voltages Vr and, as a consequence, V-. Otherwise, if the voltage V- is higher than the band-gap reference voltage Vbg, the gate voltage Vg decreases, in turn causing a decrease of the current sunk by the transistor Tr. Accordingly, the current flowing through the two bipoles Z1 and Z2 decreases causing a decrease of the voltages Vr and V-. As a consequence, the negative feed-back regulates the voltage Vr at a node of the feed-back circuit branch 212 according to the equalization of the voltages at the two input terminals of the operational amplifier 210. By properly sizing the transistor Tr and the two bipoles Z1 and Z2, a regulated voltage Vr at the source terminal of the transistor Tr takes a desired down-converted voltage value, such as for example 1.8 V or even lower.

The gate voltage Vg reached at the output terminal of the operational amplifier 210 properly biases also the gate terminals of the transistors Tsb of the stand-by voltage driver 220 and of the transistors T-1 ― T-N of the additional voltage drivers 225-1 - 225-N, in such a way that they are made conductive. However, the number of additional voltage drivers 225-1 - 225-N enabled to sunk a current from the voltage supply line Vdd is controlled by the control unit 230, that dynamically compares the regulated voltage Vr and the down-converted voltage Vo during the operation of the flash memory.

A variation of the current required by the flash memory circuits coupled to the down-converted voltage supply line Vo inevitably causes a variation of the value of the down-converted voltage Vo. The VDC 125 according to the present invention is responsive to such a variation, and the need of a greater or smaller current is compensated by the enabling or the disabling of a number of switches SW-1 - SW-N that depends on the comparison between the current value of the down-converted voltage Vo and the value of the regulated voltage Vr.

By enabling or disabling one or more *(e.g.,* a number) of the switches SW-1 - SW-N, the control unit 230 performs a sort of modulation of the width W of an hypothetic, equivalent single transistor, formed by the parallel of the MOS transistors Tsb and T-1 ― T-N considered as a whole. By modulating the transistor width W, a variation of the transistor transconductance shown by the MOS transistors Tsb and T-1 - T-N in parallel considered as a whole permits to increase or decrease the current sunk from the voltage supply line Vdd during the operation of the flash memory.

Accordingly, if the down-converted voltage Vo is lower than the regulated voltage Vr, the control unit 230 enables a greater number of switches SW-1 ― SW-N (thereby increasing the width W of the hypothetic equivalent single transistor). Otherwise, if the down-converted voltage Vo is higher than the regulated voltage Vr the control unit 230 disables a required number of switches SW-1 ― SW-N (thereby reducing the width W of the hypothetic equivalent single transistor). For example, at the power-on of the flash memory the control unit enables half of the switches SW-1 - SW-N; successively, if the down-converted voltage Vo decreases with respect to the regulated voltage Vr, the control unit 230 enables some more, possibly all of the switches SW-1 ― SW-N, whereas, if the down-converted voltage Vo increases with respect to the regulated voltage Vr, the control unit 230 disables some, possibly all of the switches SW-1 ― SW-N.

The VDC 125 according to the described embodiment of the present invention is stable irrespective of the variation of the loads at the down-converted voltage supply line Vo. The devised VDC, easily integratable in the same chip of the flash memory, is flexible and adaptive to the load variations, because it permits to regulate the down-converted voltage at the desired value also when the loads dynamically change. In addition, the VDC according to the present invention is adapted to work also when the external supply voltage Vdd increases *(e.g.* up to 4 V) or decreases (e.g. down to 2.4 V) with respect to the typical value of 3 V. Furthermore, the VDC works even if the external supply voltage Vdd is lower (e.g. below about of 2.3 V) in according to the present invention. To this purpose, a small, internal charge pump 216 may be provided, which turns on when the external supply voltage Vdd falls below a prescribed threshold, *e.g*. 2.3 V, in order to sustain the working potential of the internal nodes of the operational amplifier 210. In this conditions, VDC current consumption increases a little (e.g. up to 9 µA), but not to an unacceptable extent.

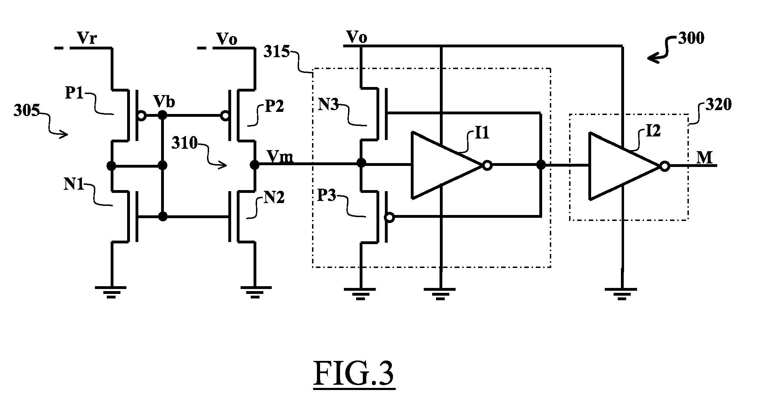

Referring to Fig. 3, a comparator 300, included in the control unit 230, according to an embodiment of the present invention is shown. The comparator 300 receives both the regulated voltage Vr and the down-converted voltage Vo, and provides a control signal M taking, for example, a high logic value '1' when the down-converted voltage Vo is higher than the regulated voltage Vr and a low logic value '0' when the down-converted voltage Vo is lower than the regulated voltage Vr.

The comparator 300 includes a reference circuit branch 305 comprising a p-MOS transistor P1 and an n-MOS transistor N1. The transistors P1 and N1 have respective drain terminals connected together, and respective gate terminals connected together; furthermore, both the transistors N1 and P1 are diode connected, i.e. they have the gate terminal connected to the respective drain terminal. The source terminal of the transistor P1 receives the regulated voltage Vr, while the source terminal of the transistor N1 is connected to ground; in this way the gate terminals of the transistors N1 and P 1 reach a bias voltage Vb depending on the regulated voltage Vr. Depending on a ratio of the sizes of the transistors N1 and P1, the bias voltage Vb can be equal, for example, to about Vr/2 (a current flowing through the reference circuit branch 305 is equal, for example, to only about 30 µA).

The comparator 300 further includes a comparison circuit branch 310 comprising a p-MOS transistor P2 and an n-MOS transistor N2; for example, the transistors N2 and P2 have substantially the same sizes as the transistors N1 and P1, respectively. The transistors P2 and N2 have respective drain terminals connected together and respective gate terminals connected to the gate terminals of the transistors N1 and P1, and thus biased at the bias voltage Vb. The source terminal of the transistor P2 receives the down-converted voltage Vo, while the source terminal of the transistor N2 is connected to ground. Accordingly, the drain terminals of the transistors N2 and P2 reach a comparison voltage Vm depending on both the down-converted voltage Vo and the bias voltage Vb (and then on the regulated voltage Vr).

The comparator 300 further includes a first amplifying stage 315 and a second amplifying stage 320, cascade-connected, for providing the control signal M, whose logic value corresponds to the comparison voltage Vm, taking a voltage value necessary to be correctly read by further control logic circuits of the control unit.

In detail, the first amplifying stage 315 comprises an inverter 11 having an input terminal receiving the comparison voltage Vm. The first amplifying stage 315 further comprises a p-MOS transistor P3 and an n-MOS transistor N3 having respective source terminals connected together to the input terminal of the inverter I1 and respective gate terminals connected together to an output terminal of the inverter I1, *i.e.* the transistors P3 and N3 are both feed-back connected in source-follower configuration with the inverter I1. The drain terminal of the transistor P3 is coupled to ground, while the drain terminal of the transistor N3 is coupled to the voltage supply line Vdd.

The second amplifying stage 320 comprises an inverter 12 having an input terminal connected to the output terminal of the inverter I1 and an output terminal providing the control signal M.

If the down-converted voltage Vo is equal to the regulated voltage Vr, a current flowing through the comparison circuit branch 310 is equal to a current flowing through the reference circuit branch 305, because the gate and source terminals of the transistors N1, N2, P1 and P2 are biased at the same voltages.

In this condition the transistors P3 and N3, feed-back connected in source-follower configuration with the inverter 11, allow maintaining the input to the inverter 11 in the trigger region thereof, then making fast a possible successive switching of the inverter 11 when the comparison voltage Vm departs from a balance condition, corresponding to the down-converted voltage Vo being substantially equal to the regulated voltage Vr.

If the down-converted voltage Vo increases with respect to the regulated voltage Vr, a current sunk by the transistor P2 increases with respect to a current sunk by the transistor N2 and, then, the comparison voltage Vm increases. This increase of the comparison voltage Vm triggers the switching of the inverter I1 and, accordingly, the cascade-connection of the two inverter I1 and 12 brings the control signal M at a voltage value (such as the down-converted voltage Vo) corresponding to the high logic value '1'.

Otherwise, if the down-converted voltage Vo decreases with respect to the regulated voltage Vr, a current sunk by the transistor P2 decreases with respect to a current sunk by the transistor N2 and, then, the comparison voltage Vm decreases. This decreasing of the comparison voltage Vm triggers the switching of the inverter I1 and, accordingly, the cascade-connection of the two inverter I1 and I2 brings the control signal M at a voltage value (such as ground) corresponding to the low logic value '0'.

The control signal M provides an indication of the necessity of increasing/decreasing the current conduction capability of the voltage drivers, and can be exploited for controlling one or more of the switches SW-1, SW-2,..., SW-N.

Simulations have been performed for evaluating the rising and falling times of the above-described comparator 300.

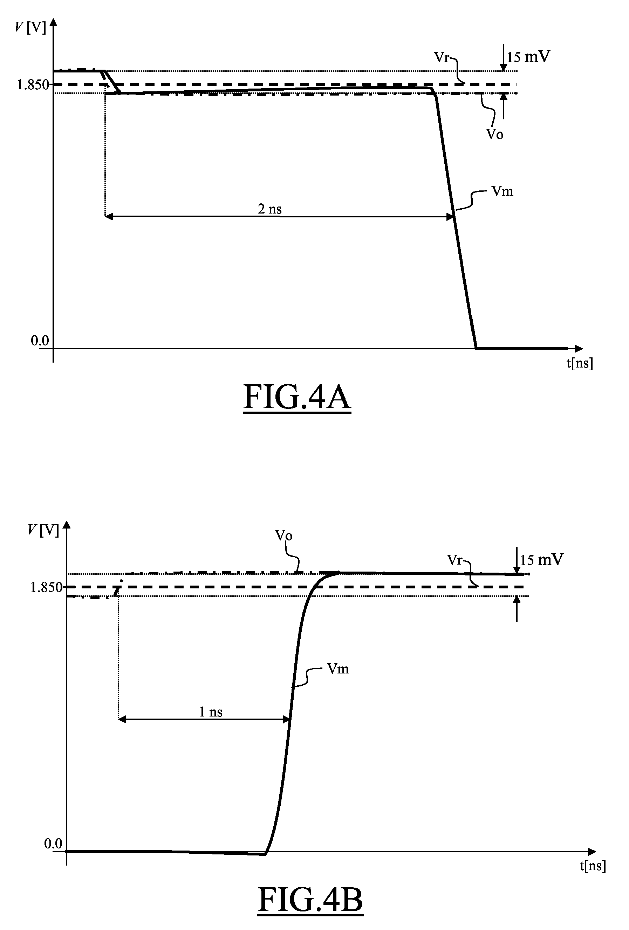

Fig. 4A shows the regulated voltage Vr (represented in dashed line), the down-converted voltage Vo (represented in dash-and-dot line) and the voltage values (represented in solid line) taken by the control signal M *vs.* time during a switching of the output of the comparator 300 from the high logic value '1' to the low logic value '0', as a consequence of a change of the order of 10 mV in the input voltage around a center value of approximately 1.85 V.

Initially, the down-converted voltage Vo is at a voltage value higher than the regulated voltage Vr, with a difference of less than a ten of millivolts and, thus, the control signal M takes a voltage value equal to the down-converted voltage Vo corresponding to the high logic value '1'. Successively, the down-converted voltage Vo decreases of about 15 mV and, after only about 2 ns, the control signal M falls at the voltage value corresponding to the low logic value '0' *(i.e.,* the ground).

Fig. 4B shows the regulated voltage Vr, the down-converted voltage Vo and the voltage values taken by the control signal M vs. time during a switching of the output of the comparator 300 from the low logic value '0' to the high logic value '1', for a similar swing of the input thereof.

In this case, initially, the down-converted voltage Vo is at a voltage value lower than the regulated voltage Vr, with a difference of less than a ten of millivolts and, then, the control signal M takes a voltage value equal to the ground. Successively, the down-converted voltage Vo increases of about 15 mV and, after only about 1 ns, the control signal M rises at the voltage value corresponding to the high logic value '1' (*i.e.,* the down-converted voltage Vo).

As a consequence, it has to be observed that the comparator has relatively low falling and rising times, also when little variations of the down-converted voltage Vo with respect to the regulated voltage Vr occurs (in the example of only 15 mV). This permits to implement a VDC having relatively low response times compatible with the operation of a flash memory, as well as a comparator with a simple architecture and operating in low power consumption.

By providing a suitable number of comparators similar in structure to the comparator shown in Figure 3 (and with properly offset switch thresholds), the various switches SW-1, SW-2,..., SW-N can be properly controlled.

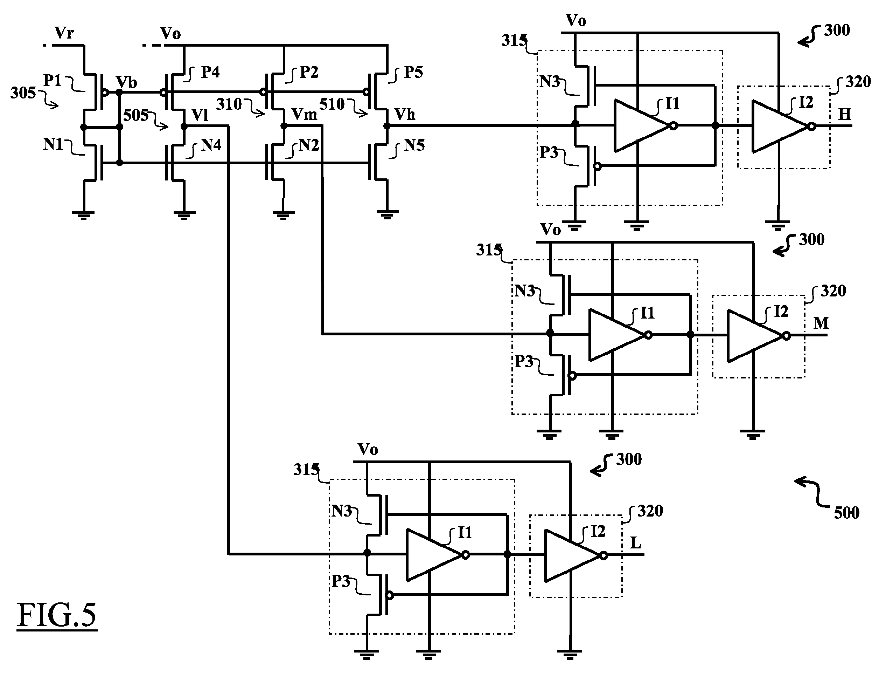

Considering now Fig. 5, a comparator 500 according to another embodiment of the present invention is shown (the elements corresponding to those depicted in Fig. 3 are denoted with the same reference numerals and their description are omitted for the sake of simplicity).

With respect to the comparator of Fig. 3, the comparator 500 includes a first further comparison circuit branch 505 and a second further comparison circuit branch 510 in addition to the reference circuit branch 305 and to the comparison circuit branch 310.

In detail, the first further comparison circuit branch 505 includes a p-MOS transistor P4 and an n-MOS transistor N4 having respective drain terminals connected together. The gate terminals of the transistors P4 and N4 are connected to the gate terminals of the transistors P1 and N1 and then are biased at the bias voltage Vb. The source terminal of the transistor P4 is connected to the voltage supply line Vdd and the source terminal of the transistor N4 is connected to ground. The sizes of the transistors P4 and P1 are such that a ratio thereof is equal to about 0.8, while the sizes of the transistors N4 and N1 are equal. The size ratio of the transistors P4 and P1, being lower than 1, introduces a negative voltage offset in the comparison between the regulated voltage Vr and the down-converted voltage Vo.

The second further comparison circuit branch 510 includes a p-MOS transistor P5 and an n-MOS transistor N5 having respective drain terminals connected together. The gate terminals of the transistors P5 and N5 are connected to the gate terminals of the transistors P 1 and N1 and then are biased at the bias voltage Vb. The source terminal of the transistor P5 is connected to the voltage supply line Vdd and the source terminal of the transistor N5 is connected to ground. The sizes of the transistors P5 and P1 are such that a ratio thereof is equal to about 1.2, while the sizes of the transistors N5 and N1 are equal. The size ratio of the transistors P5 and P1, being higher than 1, introduces a positive voltage offset in the comparison between the regulated voltage Vr and the down-converted voltage Vo.

A first further comparison voltage VI at the drain terminals of the transistors P4 and N4 is provided, similarly to the comparison voltage Vm, to two further amplifying stages 315 and 320 for providing a first further control signal L. The first further control signal L takes, for example, a high logic value '1' when the down-converted voltage Vo is higher than the regulated voltage Vr plus the negative voltage offset (*e.g*., Vr ― 25 mV) and a low logic value '0' when the down-converted voltage Vo is lower than the regulated voltage Vr plus the negative voltage offset (hereinafter the first further control signal L is referred to as low control signal L).

Similarly, a second further comparison voltage Vh at the drain terminals of the transistors P5 and N5 is provided to two further amplifying stages 315 and 320 for providing a second further control signal H. The second further control signal H takes, for example, a high logic value '1' when the down-converted voltage Vo is higher than the regulated voltage Vr plus the positive voltage offset *(e.g.,* Vr + 25 mV) and a low logic value '0' when the down-converted voltage Vo is lower than the regulated voltage Vr plus the positive voltage offset (hereinafter the second further control signal H is referred to as high control signal H).

Then, the comparator 500 provides three control signals L, M and H which can be exploited for controlling the switches SW-1, SW-2,..., SW-N, for a fine modulation of the transistor width W of the parallelly-connected voltage drivers of the down converter according to the present invention. For example, the plurality of N additional voltage drivers is logically partitioned into three subsets (for example, each one containing the same number of additional voltage drivers) and each control signal L, M and H is exploited to control a respective subset of additional voltage drivers.

It has to be observed that a precision of the voltages VI, Vm and Vh is not relevant, since some trimming structures can be provided in the flash memory (for example, based on non-volatile storage elements) can be exploited for storing an information used to adjust them during a memory testing phase.

It is pointed out that the number of comparison branches in the comparator can be lower than three, for example two comparison branches, or higher than three, for an even finer control of the modulation of the current delivery capability of the voltage drivers, and thus of the down-converted voltage.

The comparators according to the two described embodiments of the present invention, in addition to having relatively short rising and falling times, have a very flexible architecture, and a relatively low power consumption. The comparator according to the present invention is easily modifiable for introducing desired voltage offsets in the comparison between the down-converted voltage Vo and the regulated voltage Vr.

Although the present invention has been disclosed and described by way of an embodiment, it is apparent to those skilled in the art that several modifications to the described embodiment, as well as other embodiments of the present invention are possible without departing from the scope thereof as defined in the appended claims.

For example, the comparison circuit branches of the comparator can be in a number greater than three and can include, as the reference circuit branch, a different number of transistors. A different number of control signals can drive a different number of subsets of voltage drivers, for a finer control of the down-converted voltage Vo. The voltage regulator and the voltage drivers can be implemented in a different way, for example, by exploiting a different number of transistors and of switches.

## Claims

1. A voltage down converter (200) including:
voltage regulator means (205) receiving a first voltage (Vdd) and having a regulation node for providing a regulated second voltage (Vr) lower than the first voltage, and having a control node for providing a control voltage (Vg) corresponding to the second voltage; and
a voltage driver circuit branch (220) receiving the first voltage and including a variable-conductivity element (Tsb) having a control terminal coupled to the control node for controlling a current sunk by the variable-conductivity element from the first voltage, the voltage driver circuit branch having a voltage supply node (Vo) for supplying a down-converted voltage (Vo) corresponding to the second voltage, the voltage supply node being decoupled from the regulation node,
**characterized in that**
the voltage down converter further includes at least one additional voltage driver circuit branch (225-1- 225-N) receiving the first voltage and coupled to the voltage supply node, and including:
a further variable-conductivity element (T-1 - T-N) having a control terminal coupled to the control node for controlling a current sunk by the further variable-conductivity element from the first voltage; and
switching means (SW-1 ― SW-N) for selectively enabling the further variable-conductivity element so as to keep the down-converted voltage at a prescribed value depending on the regulated second voltage.

2. The voltage down converter according to claim 1, wherein the voltage regulator means include a feedback network (Tr,Z1,Z2) including a closed-loop controlled variable-conductivity element (Tr) having a control terminal coupled to the control node for controlling a current sunk by the closed-loop controlled variable-conductivity element from the first voltage, the regulation node being on the feedback network.

3. The voltage down converter according to claim 1 or 2, further including at least one comparator (300) receiving the regulated voltage and the down-converted voltage and providing an indication adapted to control the switching means of the at least one additional voltage driver circuit branch.

4. The voltage down converter according to claim 3, wherein the comparator includes:
a reference circuit branch (305) receiving the regulated voltage and having a node for providing a bias voltage (Vb) corresponding to the regulated voltage, and
at least one comparison circuit branch (310,505,510) receiving the down-converted voltage, having a bias node for receiving the bias voltage, and having a comparison node for providing a comparison voltage (Vm,VI,Vh) indicative of the comparison between the regulated voltage and the down-converted voltage.

5. The voltage down converter according to claim 4, wherein the comparator further includes amplifying means (315,320) for providing an amplified voltage corresponding to the comparison voltage, the amplifying means including at least one inverter (I1), a p-MOS transistor (P3) and an n-MOS transistor (N3) coupled in source-follower configuration to the inverter, the p-MOS and n-MOS transistors both having a respective control terminal coupled to an output terminal of the inverter and a respective current delivery terminal coupled to an input terminal of the inverter.

6. The voltage down converter according to any claim from 1 to 5, including a plurality of additional voltage driver circuit branches (225-1 ― 225-N) coupled to the voltage supply node.

7. The voltage down converter according to claim 6, including a plurality of comparators (500) receiving the regulated voltage and the down-converted voltage for providing a plurality of indications adapted to control the switches of the plurality of additional voltage drivers.

8. The voltage down converter according to claim 7, in which said plurality of comparators includes:
a common reference circuit branch (305) receiving the regulated voltage and having a node for providing a common bias voltage (Vb) corresponding to the regulated voltage, and
a plurality of comparison circuit branches (310,505,510) receiving the down-converted voltage, having a bias node for receiving the common bias voltage, and having each a respective comparison node for providing a respective comparison voltage (Vm,Vl,Vh) indicative of the comparison between the regulated voltage and the down-converted voltage.

9. A memory device (100) including at least one voltage down converter according to any claim from 1 to 8.

10. A method of down-converting a voltage (Vdd), including:
generating a regulated voltage (Vr) having a prescribed value lower than said voltage by controlling in closed regulation loop a first variable-conductivity element (Tr) through a control signal (Vg); and
using the control signal to control a second variable-conductivity element (Tsb) generating a down-converted voltage from said voltage, the second variable-conductivity element being external to the regulation loop,
**characterized by** further comprising:
using the control signal to control at least one third variable-conductivity element (T-1 - T-N) arranged externally to the regulation loop and adapted to cooperating with the second variable-conductivity element in the generation of the down-converted voltage, and
selectively enabling the at least one third variable-conductivity element depending on a detected relation between the down-converted voltage and the regulated voltage.
